# EUROPEAN PATENT APPLICATION

(11) **EP 3 544 048 A1**
(43) Date of publication of application: **25.09.2019**
(21) Application number: 18189602.8
(22) Date of filing: 17.08.2018
(51) Int. Cl.: H01L 21/67, H05B 3/00

(54) **HEATING ASSEMBLY**

(30) Priority: 23.03.2018 CN 201810246349
(71) Applicant: Beijing Chuangyu Technology Co., Ltd, Beiqijia Town Changping District Beijing 102209 (CN)
(72) Inventor: GUAN, Changle, Beijing, Beijing 102209 (CN); NAN, Jianhui, Beijing, Beijing 102209 (CN); ZHANG, Jinbin, Beijing, Beijing 102209 (CN)
(74) Representative: Prescher, Gordian

(57) **Abstract**

The present disclosure provides a heating assembly arranged below a carrier plate, including a first heating unit and a second heating unit arranged up and down; wherein the first heating unit includes a plurality of first heating elements arranged in parallel, the second heating unit includes a plurality of second heating elements arranged in parallel; the arrangement direction of the first heating elements is perpendicular to the arrangement direction of the second heating elements, and the projections of the first heating elements and the second heating elements on a heating surface of the carrier plate constitute several annular heating zones. The heating assembly is simple in structure and rational in design. The heating surface of the carrier plate is divided into a plurality of annular zones, which effectively improves the uniformity of heating temperature distribution and process results.

## Description

### Technical Field

The present disclosure relates to the technical filed of semiconductor device processing, and particularly to a heating assembly.

### Background

At present, photoelectric devices, solar devices and semiconductor devices are normally manufactured by processing the substrate surfaces with a variety of manufacturing techniques. The method is widely used that the epitaxial film or material is grown or deposited on the substrate by chemical vapor deposition (CVD) process or metal organic CVD (MOCVD) process. Epitaxial films or materials generally include layers of different compositions for specific devices such as photoelectric devices, solar devices, and the like.

CVD techniques are often classified by the reaction type or pressure, including low pressure CVD (LPCVD), atmospheric pressure CVD (APCVD), plasma enhanced CVD (PECVD) and metal organic compound CVD (MOCVD) and so on. The common features thereof are that the chamber for technical deposition is isolated from the atmosphere, and the wafer substrate in the chamber for the process of depositing the thin film needs to be heated to a certain process temperature. For example, the epitaxial process temperatures of the APCVD for silicon epitaxy and the MOCVD for depositing GaN are over 1000°C. Therefore, how to maintain the temperature uniformity at high temperatures will have a significant impact on the process results. For example, the temperature uniformity of MOCVD equipment in the LED industry is required to be within 1 °C.

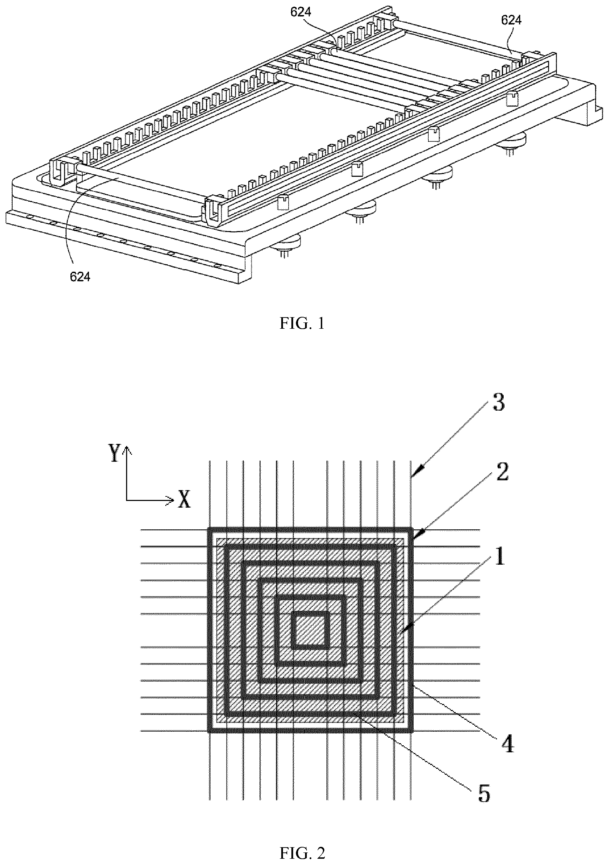

Specially, for a flat reaction chamber, as in the embodiments of the heating lamp system and method thereof disclosed by patent publication CN102422392, the wafer substrate is transferred into the process deposition chamber by the wafer carrier along the wafer carrier track, and the lower surface of the wafer carrier for supporting the wafer substrate is exposed to the energy radiated from the heating lamp assembly, meanwhile the wafer substrate is heated to the process temperature by the wafer carrier. As specifically shown in FIG.1, the infrared heating lamp assembly is disposed below the wafer carrier track, including a plurality of infrared heating lamp tubes 624 with the same mounting height, wherein the plurality of infrared heating lamp tubes 624 is arranged in parallel so as to form a heating zone. Although it is possible to independently adjust each lamp tube to control the energy radiated by the lamp tube, it can only adjust the temperature distribution in the direction of the parallel arrangement of the lamp tubes due to the parallel arrangement of the infrared heating lamp tubes above, while the temperature distribution in the direction vertical to the arrangement of the lamp tubes cannot be adjusted, that is, the power cannot be adjusted in the length direction of each lamp tube. Therefore, the temperature distribution in this direction cannot be adjusted, and thus higher uniformity cannot be provided.

### Summary

### (I) Technical problem to be solved

The objective of the present disclosure is to provide a heating assembly that is simple in structure and rational in design, and is capable of controlling the circumferential temperature distribution uniformity of the heating zone of the entire carrier plate, so as to solve the problem that the existing heating methods can only adjust the temperature distribution in a single direction so that the higher temperature uniformity cannot be met.

### (II) Technical solutions

In order to solve the technical problem above, the present disclosure provides a heating assembly provided below a carrier plate for heating a heating surface of the carrier plate, including a first heating unit and a second heating unit arranged up and down; wherein the first heating unit includes a plurality of first heating elements arranged in parallel, the second heating unit comprises a plurality of second heating elements arranged in parallel; an arrangement direction of the first heating elements is perpendicular to an arrangement direction of the second heating elements, and projections of the first heating elements and the second heating elements on the heating surface of the carrier plate constitute a plurality of annular heating zones.

According to a preferred embodiment of the technical solutions above, each of the first heating element and the second heating element includes heating sections and non-heating sections, the projections of the heating sections of the first heating elements and the second heating elements on the heating surface of the carrier plate constitute a " 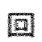 "-like shape.

According to a preferred embodiment of the technical solutions above, the first heating element and the second heating element are independently controlled heating lamp tubes including quartz glass tubes and filaments provided in the quartz glass tubes.

According to a preferred embodiment of the technical solutions above, it further includes a controller for controlling a power of each filament in the heating lamp tube.

According to a preferred embodiment of the technical solutions above, a lower surface of a tube wall of the heating lamp tube corresponding to heating section of the filament is provided with a reflective layer.

According to a preferred embodiment of the technical solutions above, the heating lamp tube includes infrared heating lamp tube.

According to a preferred embodiment of the technical solutions above, each of the first heating unit and the second heating unit further includes a lamp housing; wherein the plurality of the first heating elements and the plurality of the second heating elements are arranged in the corresponding housing at intervals, and each of the plurality of the first heating elements and the plurality of the second heating elements includes resistance wires with at least two resistance values.

According to a preferred embodiment of the technical solutions above, the heating assembly further includes a controller for separately controlling the power of the first heating unit and the second heating unit.

According to a preferred embodiment of the technical solutions above, a lower surface of a tube wall of the lamp housing corresponding to heating section of the resistance wire is provided with a reflective layer.

According to a preferred embodiment of the technical solutions above, the reflective layer includes one or more of Ag layer, Al layer, AlNd layer, quartz layer and ceramic layer.

### (III) Advantageous effects

The technical solutions of the present disclosure above have the following merits:
The present disclosure discloses a heating assembly provided below a carrier plate for heating a heating surface of the carrier plate, including a first heating unit and a second heating unit arranged up and down; wherein the first heating unit includes a plurality of first heating elements arranged in parallel, the second heating unit includes a plurality of second heating elements arranged in parallel; the arrangement direction of the first heating elements is perpendicular to the arrangement direction of the second heating elements, and the projections of the first heating elements and the second heating elements on a heating surface of the carrier plate constitute several annular heating zones. The heating assembly for heating the carrier plate provided by the present disclosure is simple in structure and rational in design. The heating assembly is provided with two heating units of upper and lower layer, and each heating unit includes a plurality of heating elements, and the projections of the heating elements of the two heating units on the heating surface of the carrier plate constitute several annular heating zones. In this way, the heating surface of the carrier plate can be divided into a plurality of annular zones, which effectively improves the uniformity of heating temperature distribution, avoids the temperature non-uniformity due to heating from a single direction and improves process results.

### Brief Description of the Drawings

FIG.1 is a structural diagram of the arrangement of the infrared heating lamp tubes in the prior art;
FIG. 2 is diagram of the arrangement of the heated carrier plate and the heating assembly in embodiment I of the heating assembly of the present disclosure;
FIG. 3 is diagram of the arrangement of the heating assembly in embodiment I of the heating assembly of the present disclosure.

In the drawings: 624: infrared heating lamp tube; 1: carrier plate; 2: heating section; 3: non-heating section; 4: first heating element; 5: second heating element.

### Detailed Description

In order to clearly specify the objectives, technical solutions, and advantages of the embodiments of the present disclosure, the technical solutions of the embodiments of the present disclosure will be described with reference to the accompanying drawings hereinafter. Obviously, the described embodiments are merely some but not all of the embodiments of the present disclosure. On the basis of the embodiments of the present disclosure, all other embodiments obtained by the person of ordinary skill in the art without creative work shall fall within the protection scope of the present disclosure.

### Embodiment I

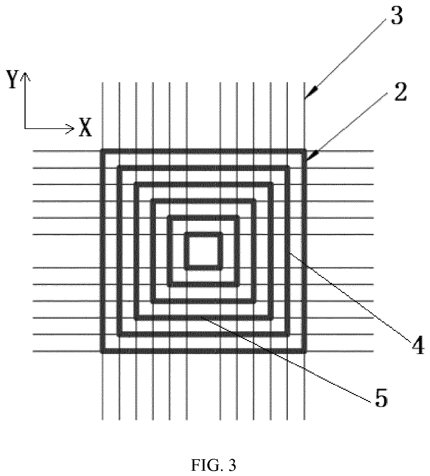

As shown in FIG.2 and FIG.3, the embodiments of the present disclosure disclose a heating assembly provided below a carrier plate 1 for heating a heating surface of the carrier plate 1, including a first heating unit and a second heating unit arranged up and down. The first heating unit includes a plurality of first heating elements 4 arranged in parallel, the second heating unit includes a plurality of second heating elements 5 arranged in parallel. The arrangement direction of the first heating elements 4 is perpendicular to the arrangement direction of the second heating elements 5, and the projections of the first heating elements 4 and the second heating elements 5 on a heating surface of the carrier plate 1 constitute annular heating zones.

In the present embodiment, the heating assembly includes the first heating unit and the second heating unit arranged up and down, that is, including two layers of heating units; the first heating unit may be arranged above the second heating unit, or may be arranged below the second heating unit, the specific arrangement may be appropriately made according to actual implementation conditions. The first heating unit includes a plurality of the first heating elements 4 arranged vertically (i.e., parallel to the Y axes in FIG. 2), the second heating unit includes a plurality of the second heating elements 5 arranged horizontally (i.e., parallel to the X axes in FIG. 2). The first heating elements 4 and the second heating elements 5 constitute the heating zone for heating the carrier plate 1; and the projections of the first heating elements 4 and the second heating elements 5 on a heating surface of the carrier plate 1 constitute annular heating zones. In this way, the heating surface of the carrier plate 1 can be divided into a plurality of annular zones, which effectively improves the uniformity of heating temperature distribution, solves the temperature non-uniformity issue due to heating from a single direction and facilitates the improvement of process results.

Specially, in the present embodiment, the heated square carrier plate 1 is placed above the upper heating unit and parallel to the heating elements in plane, and the size of the carrier plate 1 is generally smaller than the area of the heating zone so as to ensure the temperature uniformity. In addition, the heating assembly provided by the present disclosure is simple in structure and rational in design, has uniform heating temperature and good practicability, which facilitates the standardized production and promotion.

According to a preferred embodiment of the technical solutions above, the first heating elements 4 and the second heating elements 5 include heating sections 2 and non-heating sections 3. The projections of the heating sections 2 of the first heating elements 4 and the second heating elements 5 on the heating surface of the carrier plate 1 constitute a " 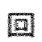 "-like shape.

After the first heating elements 4 and the second heating elements 5 are arranged, as shown in FIG. 2 and FIG.3, the thick lines refer to the heating sections 2, and the remaining connected thin lines refer to the non-heating sections 3 which do not generate heat theoretically. In this way, when the first heating unit and the second heating unit are arranged up and down, even though the projections of the non-heating sections 3 of the first heating elements 4 and the second heating elements 5 on the heating surface of the carrier plate 1 are overlapped, the projections of the heating sections 2 of the first heating elements 4 and the second heating elements 5 on the heating surface of the carrier plate 1 are jointed front-to-end, so as to form a plurality of " 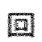 "-shaped annular heating zones, which further improves the uniformity of the heating temperature distribution.

According to a preferred embodiment of the technical solutions above, the first heating elements 4 and the second heating elements 5 are independently controlled heating lamp tubes including quartz glass tubes and filaments provided in the quartz glass tubes.

In the present embodiment, the first heating elements 4 and the second heating elements 5 are independently controlled heating lamp tubes composed of quartz glass tubes and filaments. Wherein as shown in FIG. 2 and FIG.3, the thick lines refer to filament heating zones, and the remaining connected thin lines refer to filament conductive portions which do not generate heat theoretically.

As shown in the top view, the heating sections 2 of the first heating elements 4 and the second heating elements 5 form several concentric squares, and each side (filament) of each square is individually controllable in power. In the case that all the heating lamp tubes are heating with a same power, the heated carrier plate 1 will present a temperature distribution with a hot center and cold surroundings. With the arrangement of the present disclosure, the carrier plate 1 can be divided into a plurality of annular zones, and the heating power of each zone can be controlled separately, and the heating power of four sides of each annular zone can also be individually controlled so as to compensate for the unsymmetrical thermal field caused by other factors of the system.

The circumferential temperature distribution uniformity of the heating zone of the entire carrier plate 1 can be controlled by adjusting the power of each filament.

According to a preferred embodiment of the technical solutions above, the heating assembly further includes a controller for controlling the filament power of each heating lamp tube.

In addition, the heating assembly provided by the present disclosure further includes a controller which is able to control the filament current of each heating lamp tube in real time according to the temperature change of the carrier plate 1 during heating, so that the temperature of the plurality of annular heating zones are distributed uniformly.

According to a preferred embodiment of the technical solutions above, the lower surface of the tube wall of the heating lamp tube corresponding to the filament heating section is provided with a reflective layer.

Preferably, in the present embodiment, the lower surface of the tube wall of the heating lamp tube is provided with a reflective layer, so as to ensure that the heating power of the filament is radiated upward and the heating efficiency is improved. Since the wall of the lamp tube is transparent, although the high temperature zone of the lower filament is shielded by the upper lamp tube, the infrared radiation efficiency thereof is not affected, and the upper lamp tube is not heated by the lower lamp tube. Since the carrier plate 1 is parallel to the plane composed of the lamp tubes, the heating distance has no influence on the heat radiation efficiency. Therefore, with the arrangement of two layers of lamp tubes, although the distances between the filaments and the carrier plate 1 are different, the heating uniformity is barely affected.

According to a preferred embodiment of the technical solutions above, the reflective layer includes one or more of Ag layer, Al layer, AlNd layer, quartz layer and ceramic layer.

Specifically, the reflective layer may be an alloy combination of one or more of gold, silver, copper, aluminum, nickel, and chromium, or a non-metallic material such as quartz or ceramic. Preferably, in the present embodiment, the reflective layer is Ag (silver) layer, Al (aluminum) layer, AlNd (Aluminum alloy neodymium) layer, quartz layer or ceramic layer to ensure a better reflection effect, wherein the material of the reflective layer can be determined reasonably according to actual implementation conditions.

According to a preferred embodiment of the technical solutions above, the heating lamp tube includes infrared heating lamp tube.

Preferably, in the present embodiment, the heating lamp tube adopts an infrared heating lamp tube. The infrared heating has a fast speed and great heating effect, and improves the heating efficiency of the carrier plate 1. In addition, the infrared heating lamp tube can change the shape, size, power and wavelength according to the heating demands. Therefore, it can reach to the required temperature whenever and wherever needed, and is highly flexible.

### Embodiment II

The difference from embodiment I lies in only that:
According to a preferred embodiment of the technical solutions above, each of the first heating unit and the second heating unit further includes a lamp housing. The plurality of the first heating elements and the plurality of the second heating elements are arranged in the corresponding housing respectively at intervals, and each of the plurality of the first heating elements and the plurality of the second heating elements includes resistance wires with at least two resistance values.

In the present embodiment, the first heating unit includes a first lamp housing and the plurality of the first heating elements arranged therein in parallel at intervals; correspondingly, the second heating unit includes a second lamp housing and the plurality of the second heating elements arranged therein in parallel at intervals. As shown in the top view, the heating sections of the first heating elements and the second heating elements form several concentric squares. In the case that all the heating lamp tubes are heating with a same power, the heated carrier plate will present a temperature distribution with a hot center and cold surroundings. In the present disclosure, each of the plurality of the first heating elements and the plurality of the second heating elements is configured to include resistance wires with at least two resistance values, so as to compensate for the unsymmetrical thermal field caused by other factors of the system when current is accessed.

The circumferential temperature distribution uniformity of the heating zone of the entire carrier plate can be controlled by adjusting the power of the different grouped heating lamps.

According to a preferred embodiment of the technical solutions above, the heating assembly further includes a controller for separately controlling the power of the first heating unit and the second heating unit.

In addition, the heating assembly provided by the present disclosure further includes a controller which is able to control the current of the first heating unit and the second heating unit in real time according to the temperature change of the carrier plate during heating, so that the temperature of the plurality of annular heating zones are distributed uniformly.

According to a preferred embodiment of the technical solutions above, the lower surface of the tube wall of the lamp housing corresponding to the heating section of the resistance wire is provided with a reflective layer. The lamp housing is made of transparent quartz glass.

Similar to embodiment I, in the present embodiment, the lower surface of the tube wall of the lamp housing is provided with a reflective layer, so as to ensure that the heating power of the filament is radiated upward and the heating efficiency is improved. Preferably, the reflective layer may adopt an alloy combination of one or more of gold, silver, copper, aluminum, nickel, and chromium, or may be made of a non-metallic material such as quartz or ceramic.

Other technical features are the same as those in embodiment I, and are not repeated in order to avoid redundancy.

In summary, the embodiments above of the present disclosure discloses a heating assembly provided below a carrier plate for heating a heating surface of the carrier plate, including a first heating unit and a second heating unit arranged up and down; wherein the first heating unit includes a plurality of first heating elements arranged in parallel, the second heating unit includes a plurality of second heating elements arranged in parallel; the arrangement direction of the first heating elements is perpendicular to the arrangement direction of the second heating elements, and the projections of the first heating elements and the second heating elements on a heating surface of the carrier plate constitute several annular heating zones. The heating assembly for heating the carrier plate provided by the present disclosure is simple in structure and rational in design. The heating assembly is provided with two heating units of upper and lower layer, and each heating unit includes a plurality of heating elements, and the projections of the heating elements of the two heating units on the heating surface of the carrier plate constitute several annular heating zones. In this way, the heating surface of the carrier plate can be divided into a plurality of annular zones, which effectively improves the uniformity of heating temperature distribution, solves the temperature non-uniformity due to heating from a single direction and improves the process results.

Finally, it should be noted that the embodiments above are only used to illustrate rather than to limit the technical solutions of the present disclosure; although the present disclosure has been described in detail with reference to the foregoing embodiments, those of ordinary skill in the art should understand that they can still modify the technical solutions described in the foregoing embodiments, or equivalently replace some of the technical features therein; and these modifications or replacements do not separate the essence of the corresponding technical solutions from the spirit and scope of the technical solutions of each of the embodiments of the present disclosure.

## Claims

1. A heating assembly, provided below a carrier plate 1 for heating a heating surface of the carrier plate (1), **characterized in** comprising a first heating unit and a second heating unit arranged up and down, wherein the first heating unit comprises a plurality of first heating elements (4) arranged in parallel, the second heating unit comprises a plurality of second heating elements (5) arranged in parallel; an arrangement direction of the first heating elements (4) is perpendicular to an arrangement direction of the second heating elements (5), and projections of the first heating elements (4) and the second heating elements (5) on the heating surface of the carrier plate (1) constitute a plurality of annular heating zones.

2. The heating assembly of claim 1, **characterized in that** each of the first heating element (4) and the second heating element (5) comprises heating sections (2) and non-heating sections (3), the projections of the heating sections (2) of the first heating elements (4) and the second heating elements (5) on the heating surface of the carrier plate (1) constitute a " 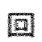 "-like shape.

3. The heating assembly of claim 1, **characterized in that** the first heating element (4) and the second heating element (5) are independently controlled heating lamp tubes comprising quartz glass tubes and filaments provided within the quartz glass tubes.

4. The heating assembly of claim 3, **characterized in that** it further comprises a controller for controlling a power of each filament in the heating lamp tube.

5. The heating assembly of claim 3, **characterized in that** a lower surface of a tube wall of the heating lamp tube corresponding to heating section (2) of the filament is provided with a reflective layer.

6. The heating assembly of claim 3, **characterized in that** the heating lamp tube comprises infrared heating lamp tube.

7. The heating assembly of claim 1, **characterized in that** each of the first heating unit and the second heating unit further comprises a lamp housing, the plurality of the first heating elements (4) and the plurality of the second heating elements (5) are arranged in the corresponding housing at intervals, and each of the plurality of the first heating elements (4) and the plurality of the second heating elements (5) comprises resistance wires with at least two resistance values.

8. The heating assembly of claim 7, **characterized in that** it further comprises a controller for separately controlling powers of the first heating unit and the second heating unit.

9. The heating assembly of claim 7, **characterized in that** a lower surface of a tube wall of the lamp housing corresponding to heating section (2) of the resistance wire is provided with a reflective layer.

10. The heating assembly of claim 5 or 9, **characterized in that** the reflective layer comprises one or more ofAg layer, Al layer, AlNd layer, quartz layer and ceramic layer.
